# EUROPÄISCHE PATENTANMELDUNG

(11) **EP 4 125 180 A1**
(43) Veröffentlichungstag der Anmeldung: **01.02.2023**
(21) Anmeldenummer: 22186657.7
(22) Anmeldetag: 25.07.2022
(51) Int. Cl.: H02J 13/00, G01R 19/00, G01R 19/25, G01R 21/06, G01R 21/133, H02J 11/00

(54) **ÜBERWACHEN EINER ÜBER EINE VERTEILSTATION BEREITGESTELLTEN ELEKTRISCHEN LEISTUNG**

(30) Priorität: 28.07.2021 DE 102021119565
(71) Anmelder: EnBW Energie Baden-Württemberg AG, 76131 Karlsruhe (DE)
(72) Erfinder: Sigle, Martin, 76189 Karlsruhe (DE)
(74) Vertreter: Durm Patentanwälte PartG mbB

(57) **Zusammenfassung**

Die Erfindung betrifft einen Sensor (14) zum Überwachen einer über eine Verteilstation (12) bereitgestellten elektrischen Leistung, mit: einer Sensor-Kommunikationseinheit (28) zum Empfangen eines Synchronisierungssignals von einem Gateway (16), wobei das Synchronisierungssignal Informationen zu einer Uhrzeit des Gateways umfasst; einer Synchronisierungseinheit (30) zum Synchronisieren einer Uhrzeit des Sensors mit der Uhrzeit des Gateways basierend auf dem Synchronisierungssignal; und einer Messeinheit (26) zum Messen einer Stromstärke eines einen Spannungsleiter (24) eines Abgangs der Verteilstation durchfließenden Wechselstroms zu einem Abtastzeitpunkt, der basierend auf der Uhrzeit des Sensors definiert ist, wobei die Sensor-Kommunikationseinheit zum Übermitteln der gemessenen Stromstärke und des zugehörigen Abtastzeitpunkts an das Gateway ausgebildet ist. Die vorliegende Erfindung betrifft weiterhin ein Gateway (16), ein System (10), zwei Verfahren und ein Computerprogrammprodukt.

## Beschreibung

Die vorliegende Erfindung betrifft einen Sensor zum Überwachen einer über eine Verteilstation bereitgestellten elektrischen Leistung. Die vorliegende Erfindung betrifft weiterhin ein Gateway zum Überwachen einer über eine Verteilstation bereitgestellten elektrischen Leistung. Zudem betrifft die Erfindung ein System und zwei Verfahren zum Überwachen einer über eine Verteilstation bereitgestellten elektrischen Leistung sowie ein Computerprogrammprodukt.

Umspannstationen (auch Netz- oder Ortsnetzstationen genannt) stellen in einem Stromnetz das Bindeglied zwischen Mittelspannung (10, 20 oder 30 kV) und Niederspannung (230 oder 400 V) dar. Derartige Umspannstationen beinhalten in der Regel eine Mittelspannungsschaltanlage, einen Transformator und eine Niederspannungsverteilung (NSV), die in einem Gehäuse (Stationsgebäude) eingebaut sind. Die Niederspannungsverteilung besteht dabei aus einer Einspeisung und mehreren Kabelabgängen, die angeschlossene Verbraucher mit Niederspannung versorgen und/oder angeschlossenen Einspeisern eingespeiste Energie abnehmen. Innerhalb der Umspannstation finden sich üblicherweise fünf bis zehn Kabelabgänge (kurz Abgänge) mit jeweils mehreren Spannungsleitern, wobei ein einzelner Kabelabgang in seinem Verlauf innerhalb eines Straßenzugs zumeist mehrere Endkunden (Verbraucher und/oder Einspeiser) versorgt. Für eine Aufteilung der Kabelstränge außerhalb der Umspannstation stehen so genannte Kabelverteilerschränke (KVS) zur Verfügung, die üblicherweise drei bis neun Kabelabgänge beinhalten. Einzelne Wohn- oder Gewerbeeinheiten sind wiederum über einen Hausanschlusskasten (HAK) an das Stromnetz angebunden. Große Gewerbeeinheiten können auch direkt an einen Kabelabgang in der Umspannstation angeschlossen sein.

Heutige Stromnetze sind primär darauf ausgerichtet, dass die Stromerzeugung fast ausschließlich zentral erfolgt. Historisch gewachsen erfolgte die Stromerzeugung zentral in großen Kraftwerken. In heutiger Zeit erfolgt jedoch die Erzeugung von Energie immer mehr auch aus regenerativen Quellen. Dabei erfolgt die Energieerzeugung teilweise dezentral in kleinen Einspeisestationen. Insbesondere der dezentral erzeugte Anteil nimmt immer weiter zu. Als Folge hiervon kann die Belastungssituation der einzelnen Kabelabgänge in der Umspannstation sowie in den KVS oder HAK stark variieren. Ebenfalls kann die Belastungssituation der verschiedenen Mittelspannungsstrecken stark variieren. Beispielsweise können an einem Kabelabgang mehrere Photovoltaikanlagen zum Einspeisen von Energie in das Niederspannungsnetz angeschlossen sein, wodurch es zu einer Spannungsanhebung über das zulässige Maß hinaus kommen kann (Überspannung).

Auch auf der Verbraucherseite ergeben sich neue Herausforderungen. Beispielsweise kann es beim Aufladen von Elektrofahrzeugen oder stationären Energiespeichern sowie auch beim Betrieb von Wärmepumpen zu kurzfristig hohen Lasten und starken Verbrauchsschwankungen kommen. Wenn an einem einzelnen Kabelabgang beispielsweise mehrere Ladepunkte für Elektrofahrzeuge angeschlossen sind, ergibt sich beim Aufladen eine starke Beanspruchung des Kabelabgangs. Hierdurch kann es zu einer Spannungsabsenkung (Unterspannung) und Überlastung der Kabelstränge kommen.

Dadurch, dass die verbaute Technologie in den allermeisten Fällen noch der Zeit entstammt, in der keine dezentrale Erzeugung sowie kein zeitabhängiger bzw. kurzfristiger Großverbrauch berücksichtigt werden musste, verfügen die Umspannstationen sowie die KVS und die HAK oft über keine integrierte Messtechnik. Eine Kenntnis der real aufgetretenen Belastungen und Lastspitzen der einzelnen Kabelabgänge im Niederspannungsnetz kann daher nur auf Basis von einzelnen Messungen vor Ort erreicht werden.

Aufgrund der Vielzahl von Kabelabgängen sowie der großen Anzahl an Mittelspannungsstrecken wird eine flächendeckende Überwachung und Messung oft als unwirtschaftlich angesehen. Gemessen wird üblicherweise lediglich punktuell an problembehafteten Abgängen bzw. Strecken, die beispielsweise durch Störungen bekannt geworden sind. Dadurch, dass keine realen Messdaten zur Verfügung stehen, erfolgt die Entwicklung der Netze zumeist basierend auf Lastannahmen unter Zugrundelegung von Lastkurven, Gleichzeitigkeiten und Prognosen. Derartige Werkzeuge sind jedoch im Zeitalter der Elektromobilität und der Verwendung von lokalen Energiespeichern und lokaler Energieeinspeisung oft nicht mehr zutreffend. Hierdurch kann es zu Engpässen bei der Leistungsbereitstellung sowie zu Spannungsproblemen kommen.

Die Strommessung im Niederspannungs- und Mittelspannungsnetz wird zumeist manuell durch Wartungspersonal vor Ort an den Umspannstationen durchgeführt. Eingesetzt werden beispielsweise induktive Stromwandler, Stromzangen, fest eingebaute induktive Wandler an Lastschaltleisten oder an der Niederspannungsverteilung, Rogowskispulen mit entsprechender Signalaufbereitung und auch Hall-Sensoren. Zusätzlich zu diesen Messgeräten muss üblicherweise ein entsprechendes abgesetztes Auswertegerät bzw. ein Datensammler, ein Datenkonzentrator oder eine Kopfstation verwendet werden, die beispielsweise als Schaltschrank oder als tragbares Messgerät ausgebildet sein können. Die Sensoren (Wandler) sind dann per Kabel mit dem entsprechenden Auswertegerät verbunden. Ein Anbringen der Sensoren direkt auf einem Spannungspotential, also auf einem nicht isolierten Teil, ist dabei zu vermeiden, da dies zu Potentialverschleppungen aufgrund der notwendigen Kabelverbindung führen kann.

Bei der Anwendung derartiger kabelgebundener Lösungen sind auch die Gefahren für das Wartungspersonal beim Anschließen und Entfernen der Geräte nicht zu unterschätzen. Die manuelle Handhabung erfordert eine Einhaltung von Sicherheitsstandards. Oftmals ist aufgrund der hohen Spannungen eine spezielle Schulung des Wartungspersonals notwendig. Zum einen ist also die Kombination aus Sensor und Auswertegerät teuer in der Anschaffung, zum anderen ist auch die Anwendung aufwendig und teuer.

In neuerer Zeit gibt es Messeinrichtungen, die über das Mobilfunknetz auslesbar sind und damit eine automatische Überwachung ermöglichen, ohne dass ein Einsatz des Betriebspersonals notwendig ist. Nachteilig an derartigen Lösungen sind insbesondere der hohe Preis sowie dass eine Vielzahl an Daten gesammelt wird, die für die Netzplanung und -überwachung nicht notwendig ist. Unabhängig davon, ob eine direkte Auslesung vor Ort oder eine Mobilfunklösung verwendet wird, stellen eine oftmals enge Einbausituation, eine vergleichsweise aufwendige Dokumentation sowie eine individuelle Parametrierung bei der Installation weitere Herausforderungen dar. Zuletzt haben bestehende Lösungen oft Nachteile bezüglich der Handhabbarkeit sowie eine vergleichsweise hohe Fehleranfälligkeit bei der Installation und Inbetriebnahme.

In diesem Zusammenhang wird in WO 2019/063147 A1 ein Überwachungsgerät zum Überwachen eines Energieparameters in einer Verteilstation offenbart. Das Überwachungsgerät ist zum Anbringen an einen Spannungsleiter in der Verteilstation ausgebildet. Das Überwachungsgerät umfasst eine Gerätekennung zum eindeutigen Kennzeichnen des Überwachungsgeräts, die dazu ausgebildet ist, aus direkter räumlicher Nähe ausgelesen zu werden. Weiterhin umfasst das Überwachungsgerät eine Messeinheit zum Messen einer Stromstärke und/oder einer Spannung eines den Spannungsleiter durchfließenden Wechselstroms. Zudem umfasst das Überwachungsgerät eine Auswerteeinheit zum Ermitteln des Energieparameters basierend auf der gemessenen Stromstärke und/oder Spannung sowie eine Kommunikationseinheit zum Empfangen einer Anfrage eines Auslesegeräts und zum Übermitteln des Energieparameters an das Auslesegerät, wenn die empfangene Anfrage eine Zugangsinformation enthält, die auf der Gerätekennung basiert.

Ausgehend hiervon stellt sich der vorliegenden Erfindung die Aufgabe, einen Ansatz zum Überwachen einer über eine Verteilstation bereitgestellten elektrischen Leistung bereitzustellen. Insbesondere soll es ermöglicht werden, auch bei engen Einbausituationen möglichst alle Abgänge erfassbar zu machen. Zudem soll insbesondere auch eine Richtung der Leistung erfasst werden können. Es soll eine Überwachung einer bereitgestellten Leistung ermöglicht werden, die kostengünstig nachträglich installiert werden kann und gleichzeitig eine geringe Fehleranfälligkeit und hohe Betriebssicherheit bietet.

Zum Lösen dieser Aufgabe betrifft die vorliegende Erfindung in einem ersten Aspekt einen Sensor zum Überwachen einer über eine Verteilstation bereitgestellten elektrischen Leistung, mit:
einer Sensor-Kommunikationseinheit zum Empfangen eines Synchronisierungssignals von einem Gateway, wobei das Synchronisierungssignal Informationen zu einer Uhrzeit des Gateways umfasst;
einer Synchronisierungseinheit zum Synchronisieren einer Uhrzeit des Sensors mit der Uhrzeit des Gateways basierend auf dem Synchronisierungssignal; und
einer Messeinheit zum Messen einer Stromstärke eines einen Spannungsleiter eines Abgangs der Verteilstation durchfließenden Wechselstroms zu einem Abtastzeitpunkt, der basierend auf der Uhrzeit des Sensors definiert ist,
wobei die Sensor-Kommunikationseinheit zum Übermitteln der gemessenen Stromstärke und des zugehörigen Abtastzeitpunkts an das Gateway ausgebildet ist.

In einem weiteren Aspekt betrifft die vorliegende Erfindung ein Gateway zum Überwachen einer über eine Verteilstation bereitgestellten elektrischen Leistung, mit:
einer Gateway-Kommunikationseinheit zum Übermitteln eines Synchronisierungssignals an einen Sensor, wobei das Synchronisierungssignal Informationen zu einer Uhrzeit des Gateways umfasst, und zum Empfangen einer Stromstärke eines einen Spannungsleiter eines Abgangs der Verteilstation durchfließenden Wechselstroms und eines zugehörigen Abtastzeitpunkts von dem Sensor;
einer Versorgungseinheit zum Empfangen einer Wechselstrom-Versorgungsspannung von der Verteilstation zur Energieversorgung des Gateways;
einem Spannungswandler zum Messen einer Spannung der Wechselstrom-Versorgungsspannung zu einem Abtastzeitpunkt, der basierend auf der Uhrzeit des Gateways definiert ist; und
einer Auswerteeinheit zum Ermitteln der elektrischen Leistung des Spannungsleiters basierend auf der gemessenen Spannung und der empfangenen Stromstärke.

Ein weiterer Aspekt der vorliegenden Erfindung betrifft ein System zum Überwachen einer über eine Verteilstation bereitgestellten elektrischen Leistung mit einem Sensor wie zuvor beschrieben und einem Gateway wie zuvor beschrieben. Das System umfasst vorzugsweise eine entfernt angeordnete Zentralstelle zum Sammeln und Weiterleiten von Informationen zu der über die Verteilstation bereitgestellten elektrischen Leistung.

Weitere Aspekte der Erfindung betreffen entsprechend dem Sensor und dem Gateway ausgebildete Verfahren sowie ein Computerprogrammprodukt zum Ausführen der Schritte des Verfahrens, wenn der Programmcode auf einem Computer ausgeführt wird. Zudem betrifft ein Aspekt der Erfindung ein Speichermedium, auf dem ein Computerprogramm gespeichert ist, das, wenn es auf einem Computer ausgeführt wird, eine Ausführung der hierin beschriebenen Verfahren bewirkt.

Bevorzugte Ausgestaltungen der Erfindung werden in den abhängigen Ansprüchen beschrieben. Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen. Insbesondere können der Sensor, das Gateway, das System, die Verfahren sowie das Computerprogrammprodukt entsprechend den für den Sensor und das Gateway in den abhängigen Ansprüchen definierten Ausgestaltungen ausgeführt sein.

Erfindungsgemäß ist es vorgesehen, dass ein Sensor direkt an einem Spannungsleiter eines Abgangs einen diesen Spannungsleiter durchfließenden Wechselstrom erfasst. Daneben wird eine Spannung in einem räumlich von dem Sensor getrennt angeordneten Gateway erfasst. Das Gateway bezieht seine Versorgungsspannung von der Verteilstation, also aus deren Stromnetz, an das auch die Abgänge angekoppelt sind, und umfasst einen Spannungswandler zum Messen der Spannung. Dabei erfolgt die Messung der Spannung im Gateway synchron (gleichzeitig bzw. zu Abtastzeitpunkten, deren zeitliche Relation bekannt ist) zur Messung des Stroms im Sensor. Es kann dann ausgehend von dem gemessenen Strom und der gemessenen Spannung im Gateway eine elektrische Leistung ermittelt werden. Hierzu wird der gemessene Strom vom Sensor an das Gateway übermittelt.

Für die Synchronisierung der Erfassung wird vom Gateway aus ein Synchronisierungssignal an den Sensor übermittelt. Das Synchronisierungssignal umfasst Informationen zu einer Uhrzeit des Gateways. Insbesondere kann eine genaue Uhrzeit übermittelt werden. Es ist aber auch möglich, dass eine Art Heartbeat-Signal oder ein vergleichbarer Ansatz verwendet werden. Basierend auf diesem empfangenen Synchronisierungssignal kann im Sensor eine Synchronisierung der Uhrzeit ermöglicht werden. Die Uhrzeit des Sensors wird in anderen Worten also basierend auf dem Synchronisierungssignal eingestellt. Nach der Synchronisierung kann eine zeitsynchrone Erfassung von Stromstärke im Sensor und Spannung im Gateway realisiert werden.

Im Vergleich zu bisherigen Ansätzen kann damit in effizienter Weise eine Erfassung einer bereitgestellten elektrischen Leistung ermöglicht werden. Insbesondere kann auch eine Richtung der Leistung in einem Abgang, also ob zum aktuellen Zeitpunkt ein Leistungsfluss vom Netz zum Verbraucher oder in die andere Richtung erfolgt, ermittelt werden. Dadurch, dass Sensor und Gateway räumlich getrennt angeordnet sind, ist es möglich, dass der Sensor ohne direkte Anbindung an eine elektrische Spannung des Wechselstroms in der Verteilstation umgesetzt werden kann. Am Sensor muss lediglich eine Stromstärke in dem Abgang ermittelt werden, die beispielsweise durch ein induktives Messprinzip erfolgen kann. Am Gateway erfolgt eine Spannungsmessung, wobei eine ohnehin am Gateway benötigte Spannungsversorgung verwendet wird. Es wird ausgenutzt, dass im Gateway, also an allen Abgängen und auch innerhalb des Gateways, der Verlauf der Wechselspannung identisch ist (zumindest an einer Phase). In anderen Worten wird also die Energieversorgung des Gateways ausgehend von der Verteilstation auch dazu verwendet, eine aktuelle Spannung an zumindest einer Phase zu ermitteln.

Das erfindungsgemäße System ermöglicht eine kosteneffiziente Messung der Leistung an verschiedenen Spanungsleitern in einer Verteilstation. Insbesondere ergibt sich eine effiziente Installierbarkeit. An die Qualifikation des Montage- und Betriebspersonals werden nur geringe Anforderungen gestellt. Zudem ergibt sich eine Installierbarkeit auch unter begrenzten Montageraumbedingungen im Bereich der Abgänge. Dies bedingt insbesondere einen einfachen nachträglichen Einbau und eine Verwendung in bestehenden Verteilstationen oder in anderen Situationen im Niederspannungs- und Mittelspannungsnetz.

In einer bevorzugten Ausgestaltung umfasst die Messeinheit einen induktiven Wandler mit einem den Spannungsleiter umschließenden Kern. Der induktive Wandler ist zum Anbringen an den Spannungsleiter teilbar ausgebildet. Der Kern umfasst vorzugsweise ein flexibles magnetisch leitfähiges Kernmaterial und ist weiter vorzugsweise aus mehreren Schichten aufgebaut. Für die eigentliche Messung der Stromstärke kann insbesondere auf ein induktives Messprinzip zurückgegriffen werden. Hierzu ist es erforderlich, dass der Spannungsleiter durch einen leitfähigen Kern umfasst bzw. umschlossen wird. Um ein derartiges Umschließen zu ermöglichen bzw. ein nachträgliches Anbringen des Überwachungsgeräts zu erlauben, ist der Kern teilbar ausgebildet. Der Kern kann also zum Anbringen an den Spannungsleiter geteilt bzw. separiert werden, um den Spannungsleiter aufzunehmen bzw. zu umschließen. Um den Kern ist dann eine Sekundärwicklung gewickelt, die zur Erfassung einer zur Stromstärke im Spannungsleiter proportionalen Spannung dient. Insbesondere ist es möglich, dass für den Kern ein flexibles magnetisch leitfähiges Kernmaterial verwendet wird. Unter einem flexiblen Material versteht sich dabei insbesondere ein Material, das nicht starr ist. Insbesondere kann die Flexibilität durch einen mehrschichtigen Aufbau erreicht werden. Die Flexibilität bewirkt eine einfache Installierbarkeit auch in beengten Platzverhältnissen. Der vorhandene Bauraum kann effizient ausgenutzt werden, indem das flexible Kernmaterial in eine dem Bauraum entsprechende Form gebogen bzw. gepresst wird. Eine hohe Messgenauigkeit sowie eine einfache nachträgliche Installierbarkeit und eine kompakte Ausführbarkeit werden erreicht.

In einer bevorzugten Ausgestaltung umfasst der Sensor einen induktiven Wandler zum Gewinnen von Energie zum Versorgen des Sensors basierend auf dem Wechselstrom im Spannungsleiter. Weiterhin umfasst der Sensor einen Energiespeicher zum Puffern der gewonnenen Energie. Der Sensor ist vorzugsweise zum Aufnehmen eines Betriebs ausgebildet, wenn ein Füllstand des Energiespeichers einen vordefinierten Mindeststand überschreitet. Als induktiver Wandler kann insbesondere derselbe Wandler wie für die Messung verwendet werden. Die Energiegewinnung basiert dann ebenfalls auf dem Wechselstrom im Spannungsleiter. Es wird eine Spannung induziert. Gewonnene Energie kann direkt für die Versorgung des Überwachungsgeräts verwendet werden. Insbesondere kann ein Energiespeicher zum Speichern der gewonnenen Energie, beispielsweise ein Akku oder ein Kondensator, verwendet werden, um hierdurch eine Pufferung bzw. einen zeitversetzten Betrieb zu ermöglichen. Ein regelmäßiger Batterietausch ist nicht erforderlich, sodass eine effiziente Wartung gewährleistet werden kann. Durch eine Aufnahme eines Betriebs bei Überschreiten eines Mindestfüllstands eines Energiespeichers kann eine einfache Installierbarkeit ermöglicht werden. Es ist kein Eingreifen des Installationspersonals erforderlich, um den Betrieb zu initiieren. Der Betrieb startet sozusagen automatisch, wenn eine ausreichende Energiemenge vorhanden ist. Die Installation wird weiter vereinfacht.

In einer bevorzugten Ausgestaltung ist die Sensor-Kommunikationseinheit zum drahtlosen Kommunizieren mit dem Gateway ausgebildet, vorzugsweise über Bluetooth-Low-Energy (BLE). Zusätzlich oder alternativ ist die Sensor-Kommunikationseinheit zum Empfangen von Synchronisierungssignalen in periodischen Zeitintervallen ausgebildet. Die Gateway-Kommunikationseinheit ist in entsprechender Weise zum drahtlosen Kommunizieren mit dem Sensor ausgebildet, vorzugsweise über Bluetooth-Low-Energy (BLE). Weiterhin ist auch die Gateway-Kommunikationseinheit vorzugsweise zum Übermitteln von Synchronisierungssignalen in periodischen Zeitintervallen ausgebildet. Durch eine Kommunikation über ein Nahbereichs-Funksystem kann eine energieeffiziente Kommunikation bei einfacher Installierbarkeit erreicht werden. Insbesondere ist es nicht erforderlich, eine Kabelverbindung zwischen dem Sensor und dem Gateway vorzusehen. Ein räumlich getrennter Betrieb kann in einfacher Weise ermöglicht werden. Dies bedingt eine einfache Installierbarkeit bzw. eine Kostenreduktion, insbesondere bei begrenztem Montageplatz. Durch einen periodischen Empfang bzw. eine periodische Übermittlung von Synchronisierungssignalen wird eine Genauigkeit der Zeitsynchronisierung verbessert. Insbesondere kann auf eine genaue Uhr im Sensor verzichtet werden, da ohnehin in regelmäßigen Abständen eine erneute Synchronisierung erfolgt. Die Kosten können insoweit reduziert werden.

In einer bevorzugten Ausgestaltung ist die Sensor-Kommunikationseinheit zum Empfangen einer Aktualisierung einer Software des Sensors von dem Gateway ausgebildet. Die Software des Sensors entspricht vorzugsweise einer Software des Gateways, deren Funktion anhand einer unterschiedlichen Hardware-Beschaltung definiert ist. Es erfolgt in anderen Worten ein Software-Update über eine Kommunikation zwischen Sensor und Gateway (insb. sog. over-theair-Aktualisierung). Durch eine vereinfachte Softwareaktualisierung kann eine Wartung vereinfacht werden bzw. ein Wartungsaufwand verringert werden. Es ist möglich, dass die Software des Sensors bzw. der Einheiten des Sensors nachträglich verändert und an mögliche zukünftige Anforderungen angepasst wird. Insbesondere ist es möglich, dass für die Software des Sensors und die Software des Gateways eine einheitliche Implementierung, also eine identische Software verwendet wird. Dies kann beispielsweise dadurch erreicht werden, dass auf dem Sensor und dem Gateway derselbe Mikrocontroller verbaut wird. Die unterschiedlichen Funktionalitäten der Einheiten des Sensors und der Einheiten des Gateways können dann dadurch erreicht werden, dass eine unterschiedliche Beschaltung vorgesehen ist. Die Software erkennt also sozusagen, ob die Funktion eines Sensors oder die Funktion eines Gateways bereitgestellt bzw. ausgeführt werden soll anhand einer entsprechenden Beschaltung. Es ergibt sich ein Kosteneinsparpotential sowie eine effiziente Umsetzungsmöglichkeit der Aktualisierung. Die Wartung wird zudem vereinfacht.

In einer bevorzugten Ausgestaltung umfasst der Sensor mehrere Messeinheiten zum Messen von Stromstärken in mehreren Spannungsleitern der Verteilstation. Die mehreren Messeinheiten sind vorzugsweise jeweils in separaten Gehäusen angeordnet und über Kabelverbindungen mit den weiteren Einheiten des Sensors verbunden. Es können insbesondere die verschiedenen Spannungsleiter eines Abgangs in der Verteilstation mit einem Sensor überwacht werden. Die mehreren Messeinheiten nutzen dabei die weiteren Einheiten des Sensors gemeinsam. Hierdurch können insoweit Kosten eingespart werden.

In einer bevorzugten Ausgestaltung umfasst das Gateway eine Verbindungseinheit zum Kommunizieren mit einer Zentralstelle und zum Übermitteln eines Energieparameters mit Informationen zu der ermittelten elektrischen Leistung des Spannungsleiters. Insbesondere können Informationen zu der gemessenen Leistung weitergegebenen werden an eine Zentralstelle. In der Zentralstelle kann dann beispielsweise eine Netzsteuerung durchgeführt werden oder auch eine entsprechende Anpassung initiiert werden. Die Zentralstelle ist dabei insbesondere als Netzleitstelle bzw. Informationseinheit des Netzbetreibers zu verstehen und räumlich entfernt bzw. beabstandet angeordnet. Dem Netzbetreiber wird insoweit ermöglicht, aus der Ferne auf die Daten bzw. die Leistungen zuzugreifen, um entsprechende Maßnahmen zu ergreifen.

In einer bevorzugten Ausgestaltung ist die Verbindungseinheit zum Empfangen eines Zeitsignals von der Zentralstelle mit Informationen zu einer Uhrzeit der Zentralstelle und zum Synchronisieren der Uhrzeit des Gateways basierend auf dem Zeitsignal ausgebildet. Zusätzlich oder alternativ ist die Verbindungseinheit als Mobilkommunikationseinheit zum drahtlosen Kommunizieren über das Internet ausgebildet. Es ist möglich, dass auch mit der Zentralstelle eine Zeitsynchronisierung erfolgt. Das Gateway empfängt insoweit eine aktuelle Uhrzeit von der Zentralstelle und synchronisiert seine eigene Uhrzeit darauf basierend. Dies ermöglicht einen synchronen Betrieb verschiedener Gateways, um eine Vergleichbarkeit der Daten bzw. der gemessenen elektrischen Leistungen sicherzustellen. Es ergibt sich eine verbesserte Überwachungsmöglichkeit. Ein Netzbetreiber oder ein anderer Beteiligter kann einen zeitsynchronen Überblick über die aktuelle Leistung an unterschiedlichen Stellen erlangen. Durch eine Anbindung über eine Mobilkommunikationseinheit kann eine einfache Installierbarkeit erreicht werden. Insbesondere kann eine Kommunikation über das Internet erfolgen, beispielsweise mittels eines LTE- oder 5G-Moduls.

In einer bevorzugten Ausgestaltung ist die Auswerteeinheit zum Ermitteln der elektrischen Leistung des Spannungsleiters basierend auf einer Bestimmung einer Phasenlage der Wechselstrom-Versorgungsspannung und einer Phasenlage des den Spannungsleiter durchfließenden Wechselstroms auf Grundlage der gemessenen Spannung und der empfangenen Stromstärke ausgebildet. Üblicherweise wird die Versorgung des Gateways basierend auf einer Phase in einem Dreiphasenwechselstromsystem vorgenommen. Demgegenüber ist an den einzelnen Abgängen bzw. Spannungsleitern auch eine Messung an den anderen Phasen sowie an einem Neutral- und/oder Schutzleiter gewünscht. Dadurch, dass am Gateway lediglich die Spannung einer Phase bestimmt wird, ergibt sich insoweit eine Herausforderung, als dass mittels des Sensors die Stromstärke auch an anderen Phasen ermittelt wird. Es ist aber möglich, ausgehend von einer Messung einer Phase auf die Lage der anderen Phasen rückzuschließen. Insbesondere kann dazu darauf zurückgegriffen werden, dass die Phasen in einem Dreiphasenwechselstromsystem um 120 ° versetzt zueinander sind. Insoweit kann durch eine entsprechende Bestimmung der Phasenlage eine Leistung an allen Phasen in einem Dreiphasenwechselstromsystem erfolgen. Es genügt, wenn die Versorgungseinheit des Gateways an eine Phase angebunden ist. Eine Messung aller Spannungsleiter wird ermöglicht. Eine einfache Installierbarkeit des Gateways durch Verwendung eines regulären Stromanschlusses wird ermöglicht.

In einer bevorzugten Ausgestaltung ist die Auswerteeinheit zum Einspeisen eines Testsignals in die Wechselstrom-Versorgungsspannung ausgebildet, das mittels der Messeinheit des Sensors detektierbar ist. Die Auswerteeinheit ist weiterhin zum Bestimmen der Phasenlage der Wechselstrom-Versorgungsspannung und der Phasenlage des den Abgang durchfließenden Wechselstroms basierend auf der empfangenen Stromstärke nach Einspeisen des Testsignals ausgebildet. Zur Bestimmung der Phasenlage kann insoweit insbesondere ein detektiertes Testsignal an die eine Phase angelegt werden. Es wird also ein Spannungssignal über die Versorgungseinheit des Gateways eingespeist, das dann zu einer detektierbaren Änderung eines Stromflusses in einem Leiter (der dieselbe Phase betrifft) führt. Durch die Detektion dieses Testsignals bzw. die dadurch ausgelöste Änderung der Stromstärke in einem Spannungsleiter kann ermittelt werden, welcher Spannungsleiter derjenigen Phase entspricht, über die auch das Gateway versorgt wird. Insoweit ergibt sich eine effizient umsetzbare Möglichkeit zur Erkennung und Bestimmung der Phasenlage der Wechselstrom-Versorgungsspannung und der Phasenlage des den Abgang durchfließenden Wechselstroms. Es wird ermöglicht, dass eine Rückrechnung zur Erkennung ausgeführt werden kann. Insoweit wird die Installierbarkeit weiter vereinfacht.

Hierin wird unter einem Strom- oder Spannungsleiter insbesondere eine elektrische Verbindung beispielsweise aus Kupferdraht verstanden, über die eine Leistung fließen kann. Ein Spannungsleiter kann dabei insbesondere ein Phasenleiter, ein Neutralleiter und/oder ein Schutzleiter sein. Eine bereitgestellte elektrische Leistung kann positiv oder negativ sein, es kann insoweit also auch eine Leistung abgenommen werden, beispielsweise eine von einer Photovoltaikanlage erzeugte Leistung. Ein Sensor kann mehrere Messeinheiten für mehrere Spannungsleiter umfassen. Üblicherweise sind innerhalb einer Verteilstation bzw. innerhalb einer Umspannstation mehrere Sensoren angeordnet, die jeweils mehrere Messeinheiten umfassen. Beispielsweise kann pro Abgang jeweils ein Sensor mit vier Messeinheiten zum Erfassen der Stromstärken in vier Spannungsleitern vorgesehen sein. Ein Gateway kann mit mehreren Sensoren verbunden sein. Eine Zentralstelle kann mit mehreren Gateways verbunden sein. Der erfindungsgemäße Ansatz eignet sich zum Einsatz in einer Verteilstation. Hierunter wird insbesondere eine Umspannstation verstanden. Ein Einsatz an einer anderen Stelle, an der eine Leistung an Spannungsleitern bzw. Kabelabgängen überwacht werden soll, ist aber ebenfalls möglich.

Die Erfindung wird nachfolgend anhand einiger ausgewählter Ausführungsbeispiele im Zusammenhang mit den beiliegenden Zeichnungen näher beschrieben und erläutert. Es zeigen:
- Figur 1: eine schematische Darstellung eines erfindungsgemäßen Systems zum Überwachen einer über eine Verteilstation bereitgestellten elektrischen Leistung;
- Figur 2: eine schematische Darstellung eines erfindungsgemäßen Sensors;
- Figur 3: eine schematische Darstellung eines erfindungsgemäßen Gateways;
- Figur 4: eine schematische Darstellung einer Messeinheit in einem erfindungsgemäßen Sensor;
- Figur 5: eine schematische Darstellung der Funktionsweise des erfindungsgemäßen Systems;
- Figur 6: eine schematische Darstellung eines Ansatzes zum Bestimmen einer Phasenlage mit einem erfindungsgemäßen System;
- Figur 7: eine schematische Darstellung eines erfindungsgemäßen Verfahrens zum Überwachen einer elektrischen Leistung in einem Gateway; und
- Figur 8: eine schematische Darstellung eines erfindungsgemäßen Verfahrens zum Überwachen einer elektrischen Leistung in einem Sensor.

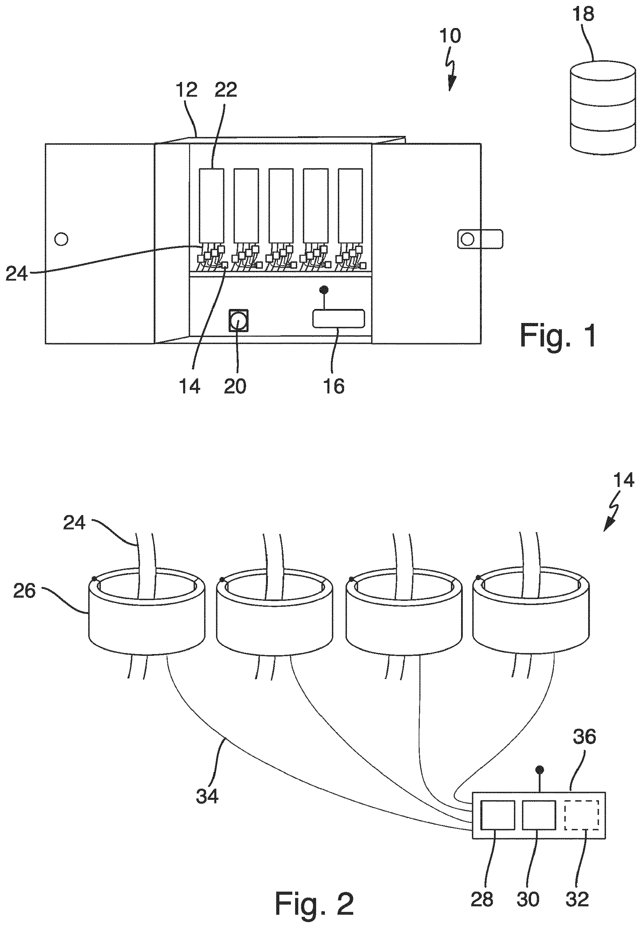

In der Figur 1 ist ein erfindungsgemäßes System 10 zum Überwachen einer über eine Verteilstation 12 bereitgestellten elektrischen Leistung dargestellt. Dargestellt ist insbesondere eine Umspannstation, die das Bindeglied zwischen Mittelspannung und Niederspannung im Stromverteilnetz bildet. In der Umspannstation wird eine eingehende Mittelspannung mittels eines Transformators in eine Niederspannung zur Versorgung von Endkunden (Verbraucher und/oder Einspeiser) umgewandelt.

Im dargestellten Ausführungsbeispiel umfasst das erfindungsgemäße System 10 fünf Sensoren 14 zum Überwachen einer über die Verteilstation 12 bereitgestellten elektrischen Leistung. Weiterhin umfasst das System 10 ein Gateway 16, das ebenfalls in der Verteilstation 12 angeordnet ist. Zudem umfasst das System 10 im dargestellten Ausführungsbeispiel eine Zentralstelle 18, die beispielsweise als Internet-Server ausgebildet sein kann und mit dem Gateway 16 in Kommunikationsverbindung steht, vorzugsweise über Mobilfunk.

Eine Mittelspannungsleitung (nicht dargestellt) ist über einen Mittelspannungsanschluss 20 an die Verteilstation 12 angeschlossen. Die Mittelspannung wird in eine Niederspannung transformiert und im dargestellten Beispiel über insgesamt fünf Abgänge 22 (Kabelabgänge) an Endkunden weitergegeben. Jeder Abgang 22 umfasst drei Phasenleiter sowie einen Neutralleiter und/oder Schutzleiter. Im dargestellten Ausführungsbeispiel des Systems 10 werden vier Spannungsleiter 24 an jedem der Abgänge 22 mit einem Sensor 14 überwacht. Es versteht sich, dass es auch möglich ist, lediglich ausgewählte Abgänge oder ausgewählte Spannungsleiter zu überwachen.

Das System 10 ermöglicht eine effiziente und situationsadäquate Überwachung bzw. Messung einer über die Verteilstation 12 bereitgestellten Leistung an den jeweils einzelnen Abgängen 22 und einzelnen Spannungsleitern 24. Hierzu ist eine Erfassung der Spannung an dem Gateway 16 und eine zeitsynchrone Erfassung eines durch einen Spannungsleiter 24 fließenden Stroms mittels des Sensors 14 vorgesehen. Aufgrund der Synchronisierung kann dann unter Zugrundelegung beider Informationen (Strom und Spannung zu den jeweiligen Abtastzeitpunkten) eine Leistung berechnet werden. Die Leistung kann dabei positiv oder negativ sein, je nachdem, ob über den Spannungsleiter 24 Leistung eingespeist oder abgegeben wird.

In der Figur 2 ist schematisch ein erfindungsgemäßer Sensor 14 dargestellt. Der Sensor 14 umfasst im dargestellten Ausführungsbeispiel insgesamt vier Messeinheiten 26 zur Erfassung des Stromes, eine Sensor-Kommunikationseinheit 28, eine Synchronisierungseinheit 30 sowie einen (optionalen) Energiespeicher 32. Die Einheiten können dabei einzeln oder kombiniert und teilweise oder vollständig in Hard- und/oder in Software ausgeführt sein. Insbesondere ist es möglich, dass die Sensor-Kommunikationseinheit 28 und die Synchronisierungseinheit 30 bzw. deren Funktionalitäten zumindest teilweise auf einem gemeinsamen Mikrocontroller in Software implementiert sind.

Im dargestellten Ausführungsbeispiel sind die Messeinheiten 26 zur Stromerfassung basierend auf einer Induktionsmessung ausgebildet, wobei der Spannungsleiter 24 jeweils von einer Art Schelle umschlossen wird. Die Messeinheiten 26 sind also jeweils in separaten Gehäusen angeordnet und über Kabelverbindungen 34 mit den weiteren Einheiten des Sensors 14 verbunden. Die Sensor-Kommunikationseinheit 28 ist zusammen mit der Synchronisierungseinheit 30 und dem Energiespeicher 32 in einem weiteren Gehäuse 36 angeordnet. Das weitere Gehäuse 36 umfasst sozusagen die Elektronikkomponenten, wohingegen die Messeinheit insbesondere einen induktiven Wandler bildet. Die dargestellte Illustration ist dabei lediglich beispielhaft zu verstehen. Es können andere Anzahlen an Messeinheiten 26 verwendet werden. Zudem können in einer der Messeinheiten bzw. in einem der Gehäuse der Messeinheiten die weiteren Komponenten des Sensors 14 integriert sein und beispielsweise weitere Messeinheiten per Kabelverbindung oder drahtlos angebunden sein. Es ist zudem möglich, dass die Messeinheit 26 teilweise ebenfalls in dem weiteren Gehäuse 36 angeordnet ist.

Über die Sensor-Kommunikationseinheit 28 ist der Sensor an das Gateway angebunden. Die Anbindung erfolgt dabei insbesondere drahtlos, beispielsweise über Bluetooth-Low-Energy oder einen anderen Kurzstrecken-Kommunikationsstandard.

Die Synchronisierungseinheit 30 dient zur Synchronisierung einer internen Uhr des Sensors mit einer Uhrzeit des Gateways. Hierzu wird ein Synchronisierungssignal ausgewertet. Das Synchronisierungssignal kann beispielsweise eine Uhrzeit in einem entsprechenden Format umfassen. Ebenfalls kann das Synchronisierungssignal aber auch in Form eines regelmäßigen (periodischen) Signals ohne weiteren Informationsinhalt empfangen werden (Heartbeat-Signal).

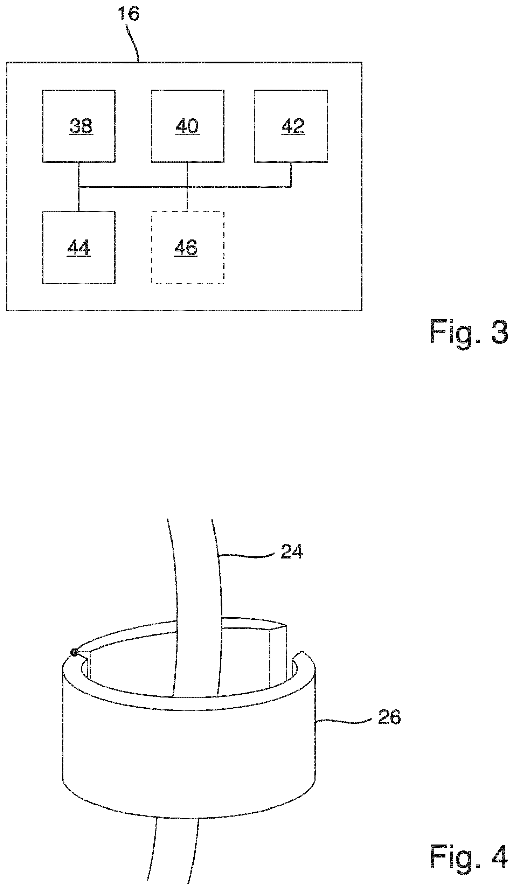

In der Figur 3 ist schematisch das Gateway 16 dargestellt. Das Gateway 16 umfasst im dargestellten Ausführungsbeispiel eine Gateway-Kommunikationseinheit 38, eine Versorgungseinheit 40, einen Spannungswandler 42 sowie eine Auswerteeinheit 44. Im dargestellten Ausführungsbeispiel umfasst das Gateway 16 weiterhin eine (optionale) Verbindungseinheit 46. Die Einheiten können dabei einzeln oder kombiniert und teilweise oder vollständig in Hard- und/oder in Software ausgeführt sein. Insbesondere ist es möglich, dass die Gateway-Kommunikationseinheit 38, die Auswerteeinheit 44 sowie ggf. die Verbindungseinheit 46 bzw. deren Funktionalitäten zumindest teilweise auf einem gemeinsamen Mikrocontroller in Software implementiert sind.

Das Gateway 16 wird direkt mit Netzspannung versorgt (Steckdose oder fest verkabelt). Insbesondere ist das Gateway 16 über die Versorgungseinheit 40 an eine Wechselstrom-Versorgungsspannung der Verteilstation angebunden. Neben der Energieversorgung kann dabei auch eine Messung der Spannung der Wechselstrom-Versorgungsspannung mittels des Spannungswandlers 42 vorgenommen werden.

Über die Gateway-Kommunikationseinheit 38 kommuniziert das Gateway 16 mit den angebundenen Sensoren. Für die Kommunikation kann hierbei insbesondere auf eine drahtlose Kommunikation zurückgegriffen werden. Beispielsweise kann ein Bluetooth-Low-Energy-Kommunikationsmodul verwendet werden. Insbesondere wird das Synchronisierungssignal an den Sensor übermittelt, vorzugsweise in periodischen Abständen und Informationen zum gemessenen Strom werden vom Sensor empfangen.

Mittels des Spannungswandlers 42 wird am Gateway 16 eine Spannung erfasst. Hierzu ist der Spannungswandler 42 an die Versorgungsspannung des Gateways 16, also an die Energieversorgung des Gateways 16, angeschlossen bzw. in diese integriert, die über die Verteilstation erfolgt. Die Spannung, die dabei gemessen wird, entspricht insbesondere hinsichtlich ihrer Frequenz und Amplitude der Spannung an zumindest einem Spannungsleiter eines Abgangs in der Verteilstation, da dieser ebenfalls an das Netz der Verteilstation angekoppelt ist. Die Erfassung erfolgt zu Abtastzeitpunkten, die basierend auf einer Uhrzeit des Gateways 16, also insbesondere ausgehend von einer Uhr des Gateways, festgelegt sind.

In der Auswerteeinheit 44 erfolgt die Ermittlung der elektrischen Leistung, insbesondere basierend auf einer Multiplikation der Spannung (am Gateway) mit dem Strom (in dem Spannungsleiter). Alternativ kann die Berechnung über eine Bestimmung der Phasenlage des Stroms am Sensor und einer Spannung am Gateway erfolgen. Insbesondere kann die Leistung in mehreren Spannungsleitern für mehrere Sensoren basierend auf dem jeweils gemessenen Strom basierend auf derselben (einen) gemessenen Spannung erfolgen. Die einzelnen gemessenen Stromstärken an den Spannungsleitern unterscheiden sich also, wohingegen die Spannung vorgegeben ist und auch zentral am Gateway erfasst wird.

Über die Verbindungseinheit 46 kann eine Kommunikation mit einer Zentralstelle erfolgen. Insbesondere kann also eine Anbindung an eine zentrale Datenablage, Auswertung und Verwaltung vorgesehen sein. Beispielsweise kann eine Cloud-Anbindung verwendet werden. Die Kommunikation zwischen Gateway 16 und Zentralstelle 18 in der Cloud kann beispielsweise über Mobilfunk (LTE, 5G etc.) erfolgen. Hierzu kann die Verbindungseinheit 46 insbesondere als Mobilkommunikationseinheit ausgebildet sein und beispielsweise basierend auf einer LTE- oder 5G-Verbindung mit dem Internet verbunden sein.

In der Figur 4 ist schematisch eine Messeinheit 26 des Sensors dargestellt. Die Messeinheit 26 umfasst insbesondere einen Kern, um den eine Sekundärwicklung angebracht ist. Der zu messende Spannungsleiter 24 bildet die Primärwicklung. Der Kern ist insoweit also teilbar und kann um den Spannungsleiter herum angebracht werden. Die Fixierung der Messeinheit erfolgt mittels eines Klemmblocks mithilfe einer Flügelmutter oder auch mithilfe eines Federklemm-Mechanismus.

Insbesondere kann dabei die Messeinheit 26 einen Wandler mit einem flexiblen magnetisch leitfähigen Kernmaterial umfassen, das vorzugsweise aus mehreren Schichten aufgebaut ist, um das die Sekundärwicklung angebracht ist. Der zu messende Leiter 24 bildet die Primärwicklung. Insbesondere kann die Messeinheit 26 also einen induktiven Wandler umfassen, um so eine Erfassung des den Spannungsleiter 24 durchfließenden Wechselstroms zu ermöglichen. Dadurch, dass sich der Wandler reversibel verformen lässt, kann eine Anpassung an die Gegebenheiten bei der Montage erfolgen, ohne dass hierfür die magnetischen Eigenschaften und damit die Messgüte beeinflusst werden.

Zudem kann mittels des Wandlers bzw. mittels der Messeinheit 26 eine induktive Energiegewinnung erfolgen. Die Wechselspannung im Spannungsleiter 24 induziert eine Spannung in der Sekundärwicklung. Der Wandler vereint insoweit also eine Flexibilität bei der Montage (wie sie beispielsweise bei einer Rogowski-Spule gegeben ist) mit der für die Energieversorgung des Sensors erforderlichen Tatsache, dass gleichzeitig eine Leistungsübertragung möglich ist (Energy Harvesting).

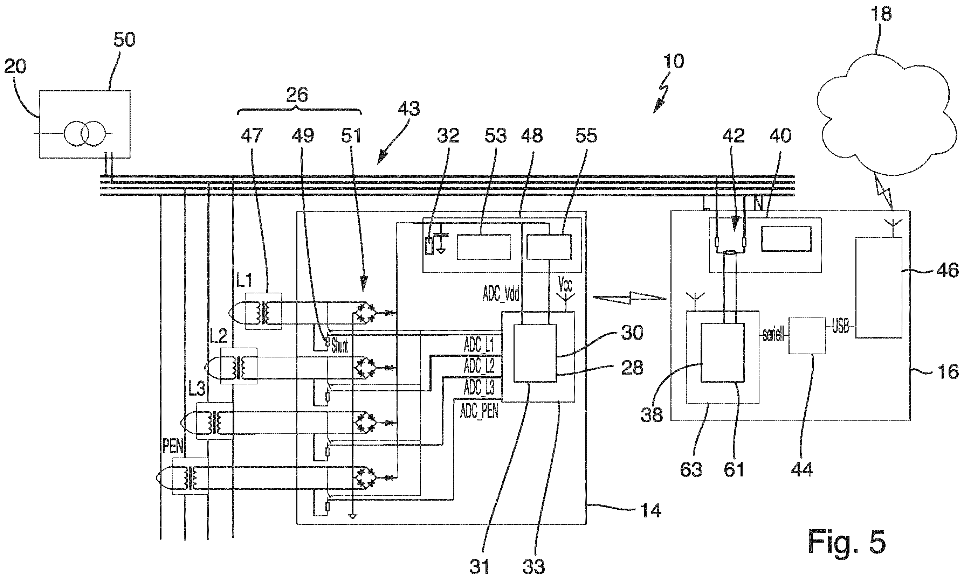

In der Figur 5 ist schematisch eine Funktionsübersicht des erfindungsgemäßen Systems 10 dargestellt. Der Sensor 14 steht in Kommunikation mit dem Gateway 16, beispielsweise über Bluetooth-Low-Energy oder einen anderen Kurzstrecken-Kommunikationsstandard. Das Gateway 16 steht in Kommunikation mit der Zentralstelle 18, beispielsweise über eine Mobilfunkverbindung. Weiter dargestellt sind der Mittelspannungsanschluss 20 sowie der Trafo 50, über den die Verteilstation die weiterzugebende Niederspannung erzeugt. Die Energieversorgung bzw. Energieverteilung erfolgt über eine Sammelschiene 43.

Der Sensor 14 umfasst eine Sensor-Kommunikationseinheit 28, eine Synchronisierungseinheit 30, vier Messeinheiten 26 sowie einen Energiespeicher 32, der als Supercap ausgebildet ist und innerhalb einer Energieversorgungseinheit 48 angeordnet ist. Im dargestellten Ausführungsbeispiel sind die Sensor-Kommunikationseinheit 28 und die Synchronisierungseinheit 30 insbesondere in Software implementiert, die auf einem Mikrocontroller 31 eines Funkmoduls 33 ausgeführt wird.

Mittels des Sensors 14 bzw. mittels der vier Messeinheiten 26 wird eine Strommessung an insgesamt vier Spannungsleitern L1, L2, L3, PEN vorgenommen. Hierzu wird jeweils an einem induktiven Wandler 47 mittels Shunt-Widerständen 49 ein Messsignal abgegriffen, das dann in dem Mikrocontroller 31 verarbeitet wird. Die Abtastung bzw. Messung der Stromstärke in dem Spannungsleiter kann dabei beispielsweise fünftausendmal pro Sekunde erfolgen.

Zudem wird über die Gleichrichter 51 eine Gleichspannung gewonnen, über die dann eine Energieversorgung des Sensors 14 erfolgen kann. Die Energieversorgungseinheit 48 umfasst insbesondere einen Überspannungsschutz 53 sowie einen Spannungsregler 55. Im dargestellten bevorzugten Ausführungsbeispiel beginnt der Mikrocontroller 31 bzw. die Sensor-Kommunikationseinheit 28 des Sensors 14 zu arbeiten, sobald genügend Energie in einen Pufferkondensator (Supercap) geladen wurde, um die Energieversorgung zu gewährleisten. Der Sensor 14 nimmt also seinen Betrieb auf, wenn ein Füllstand des Energiespeichers einen vordefinierten Mindeststand überschreitet. Gleichzeitig erfolgt eine Überwachung des Energiespeichers, um ein Überladen zu verhindern. Nach dem Systemstart sendet der Sensor 14 periodisch Pakete (Advertising), um vom Gateway 16 erkannt zu werden.

Üblicherweise erfolgt bei der Nutzung von Stromwandlern zur Energieversorgung eine Umschaltung zwischen Messen und Laden. Hierdurch ist während des Ladens eine Messwerterfassung nicht möglich. Um eine kontinuierliche Stromwerterfassung zu ermöglichen, kann eines oder eine Kombination aus nachfolgenden Verfahren angewendet werden: Abtastung einer Halbwelle der Netzperiode und Energieversorgung in der anderen Halbwelle; Erfassung des Gesamtstroms im Eingangspfad und Berücksichtigung sowie Kompensation der sich durch die Impedanz der Ladeschaltung ergebenden Phasenverschiebung.

Über die Versorgungseinheit 40 des Gateways 16 wird von der Verteilstation eine Wechselstrom-Versorgungsspannung empfangen. Insbesondere ist die Versorgungseinheit 40 an eine Phase eines 230 V-Anschlusses angebunden. Mittels eines Spannungswandlers 42 kann die Spannung der Wechselstrom-Versorgungsspannung zu einem Abtastzeitpunkt gemessen werden. Die Abtastung der Spannung mittels des Spannungswandlers 42 des Gateways 16 erfolgt vorzugsweise mit derselben Abtastfrequenz wie die Strommessung in dem Sensor 14. Über die Gateway-Kommunikationseinheit 38 erfolgt die Kommunikation mit dem Sensor 14 bzw. dessen Sensor-Kommunikationseinheit 28. Die Gateway-Kommunikationseinheit 38 ist dabei in Software implementiert, die auf einem Mikrocontroller 61 eines Funkmoduls 63 ausgeführt wird.

Auf dem Gateway 16 werden die gemessenen Größen (Strom und Spannung) verknüpft, um hieraus insbesondere die Stromrichtung und die Leistung bestimmen zu können. In der Auswerteeinheit 44 wird eine elektrische Leistung basierend auf der gemessenen Spannung und der empfangenen Stromstärke ermittelt. Die bereitgestellte elektrische Leistung an einem Spannungsleiter ergibt sich also insbesondere aus einer Multiplikation. Diese Daten werden gegebenenfalls noch aggregiert (z. B. 15-Minuten-Mittelwert, Minimum, Maximum ...) und über die Verbindungseinheit 46 per Mobilfunk an die Zentralstelle 18 (Backend) übertragen.

Das Gateway 16 synchronisiert nach Anlegen der Versorgungsspannung die interne Uhrzeit des Gateways (per Mobilfunk, NTP oder bei kurzzeitiger Spannungsunterbrechung über die interne RTC) und sucht dauerhaft nach registrierten Sensoren 14 in der Umgebung. Sobald ein neuer Sensor 14 erkannt wird, wird eine Verbindung zu diesem Sensor 14 hergestellt. Nach erfolgreicher Verbindung wird die Uhrzeit des Gateways 16 an den Sensor 14 übertragen. Diese wird im Betrieb dann vorzugsweise in regelmäßigen Abständen aktualisiert und lokal auf dem Sensor 14 nachgeführt.

Vorteilhafterweise ist eine nachträgliche funktionale Erweiterbarkeit vorgesehen. Um eine derartige nachträgliche Erweiterbarkeit ohne Austausch der Hardware zu ermöglichen, erfolgt die Signalverarbeitung vollständig digital. Gleichzeitig kann die Datenverarbeitung durch ein Softwareupdate aus der Ferne angepasst und erweitert werden. Die zu erfassenden Messwerte werden also unmittelbar digitalisiert und die Weiterverarbeitung erfolgt in einem Mikrocontroller.

Vorteilhafterweise ist es vorgesehen, dass das Funkmodul 63 des Gateways 16 auf derselben Art von Mikrocontroller wie der Sensor 14 basiert. Die unterschiedliche Funktionalität der Software auf dem Funkmodul 63 des Gateways 16 und den Sensoren 14 kann dann durch eine Konfiguration (beispielsweise durch eine externe Beschaltung) hergestellt werden. Für ein Ausrollen eines Softwareupdates kann dann auf die drahtlose Kommunikation zwischen Gateway 16 und Sensoren 14 zurückgegriffen werden. Die Software kann von der Zentralstelle ausgehend an das Gateway 16 übertragen werden. Von dem Gateway 16 ausgehend kann die Software dann an die einzelnen angebundenen Sensoren 14 gespiegelt werden. Dies vereinfacht den Vorgang der Erstellung von Updates für das Funkmodul 63 des Gateway 16 und die Sensoren 14.

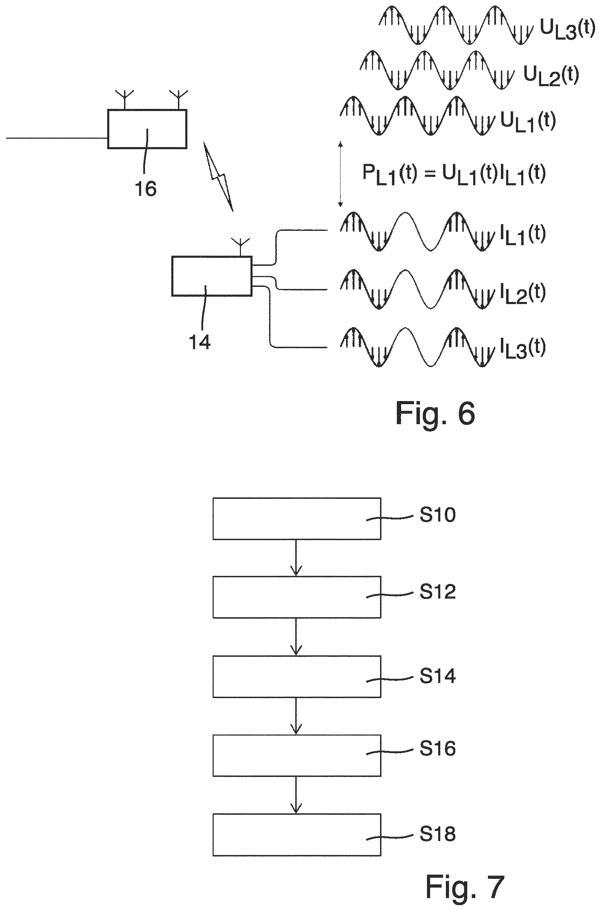

In der Figur 6 ist schematisch die Kommunikation zwischen Gateway 16 und Sensor 14 dargestellt.

Im Gateway 16 wird die Spannung an der vorhandenen Wechselstrom-Versorgungsspannung gemessen. Hierbei wird üblicherweise lediglich an einer Phase gemessen. Im dargestellten Beispiel wird eine Spannung U_{L1}(t) an der L1-Phase über die Zeit t gemessen. Dargestellt sind die jeweiligen Abtastzeitpunkte und Messwerte. Ausgehend von einer Strommessung an der L1-Phase mittels des Sensors 14 könnte also die bereitgestellte elektrische Leistung zu P_{L1}(t)=U_{L1}(t)*I_{L1}(t) ermittelt werden. Durch die zeitsynchrone dreiphasige Strommessung mittels des Sensors 14 kann dann eine Berechnung der Leistung und Leistungsflussrichtung erfolgen. Vorzugsweise wird die Berechnung dabei im Gateway 16 vorgenommen. Das Gateway 16 wird also direkt mit Netzspannung versorgt (Steckdose oder fest verkabelt). Gleichzeitig dient der einphasige 230 V-Anschluss auch zur Messung der Spannung.

Im Sensor 14 kann jedoch durch Verwenden mehrerer Messeinheiten eine Messung der Stromstärke an allen drei Phasen L1, L2, L3 erfolgen. Für die Auswertung der Spannung ist die Zuordnung des gemessenen Außenleiters erforderlich. Um eine Bestimmung der Leistung in den einzelnen Spannungsleitern bzw. der bereitgestellten elektrischen Leistung über die drei Phasen vornehmen zu können, ist es demnach erforderlich, die Spannungskurve bzw. den Spannungsverlauf U_{L2}(t) und U_{L3}(t) zu erfassen bzw. zu prädizieren, die nicht gemessen werden. Hierzu kann auf die festen Phasenbeziehungen in einem Dreiphasen-Wechselstromsystem zurückgegriffen werden und die Spannung an den weiteren Phasen geschätzt werden.

Alternativ ist eine Ermittlung der Leistung möglich durch eine Bestimmung eines Betrags und einer Phase der Ströme L1, L2, L3 aus der Wellenform am Sensor, eine Übermittlung von Strombetrag und -phase (Vektor/Stromzeiger) an das Gateway, eine Bestimmung von Spannungsbetrag und -phase (Vektor/Spannungszeiger) aus der Wellenform am Gateway und eine Berechnung der Leistung durch Multiplikation von komplexen Spannungen und komplexen Strömen am Gateway.

Insoweit ist eine automatisierte Detektion des an das Gateway 16 angeschlossenen Außenleiters vorteilhaft. Diese automatisierte Detektion kann insbesondere auch durch eine Einspeisung von Testsignalen am Gateway 16 erfolgen, wobei die Testsignale dann an dem Sensor 14 bzw. den Sensoren ausgewertet werden. Hierzu wird für die eingespeisten Testsignale eine Frequenz gewählt, die so hoch ist, dass ein Übersprechen auf die übrigen Außenleiter gering ist und gleichzeitig hoch genug, um den Implementierungsaufwand bei der Signalkopplung möglichst gering zu halten.

In der Figur 7 ist schematisch ein erfindungsgemäßes Verfahren zum Überwachen einer über eine Verteilstation bereitgestellten elektrischen Leistung in einem Gateway dargestellt. Das Verfahren umfasst Schritte des Übermittelns S10 eines Synchronisierungssignals, des Empfangens S12 einer Stromstärke, des Empfangens S14 einer Wechselstrom-Versorgungsspannung, des Messens S16 einer Spannung und des Ermittelns S18 der elektrischen Leistung.

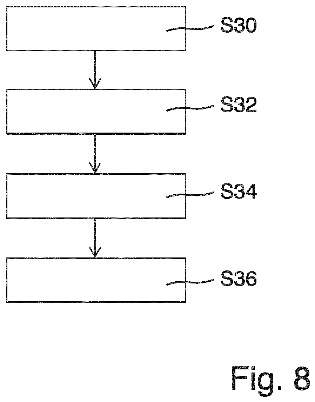

In entsprechender Weise ist in der Figur 8 schematisch ein Verfahren zum Überwachen einer über eine Verteilstation bereitgestellten elektrischen Leistung in einem Sensor dargestellt. Das Verfahren umfasst Schritte des Empfangens S30 eines Synchronisierungssignals, des Synchronisierens S32 einer Uhrzeit, des Messens S34 einer Stromstärke und des Übermittelns S36 der gemessenen Stromstärke.

Die Verfahren können insbesondere in Software implementiert sein, wobei die Software auf einem Mikrocontroller in einem Sensor bzw. einem Gateway ausgeführt wird. Dabei ist es möglich, dass eine einheitliche Software sowohl für den Sensor als auch für das Gateway bzw. für die jeweiligen Mikrocontroller verwendet wird. Dies hat den Vorteil, dass für eine Softwareaktualisierung ein Spiegelungsprozess verwendet werden kann.

Die Erfindung wurde anhand der Zeichnungen und der Beschreibung umfassend beschrieben und erklärt. Die Beschreibung und Erklärung sind als Beispiel und nicht einschränkend zu verstehen. Die Erfindung ist nicht auf die offenbarten Ausführungsformen beschränkt. Andere Ausführungsformen oder Variationen ergeben sich für den Fachmann bei der Verwendung der vorliegenden Erfindung sowie bei einer genauen Analyse der Zeichnungen, der Offenbarung und der nachfolgenden Patentansprüche.

In den Patentansprüchen schließen die Wörter "umfassen" und "mit" nicht das Vorhandensein weiterer Elemente oder Schritte aus. Der undefinierte Artikel "ein" oder "eine" schließt nicht das Vorhandensein einer Mehrzahl aus. Ein einzelnes Element oder eine einzelne Einheit kann die Funktionen mehrerer der in den Patentansprüchen genannten Einheiten ausführen. Die verschiedenen Einheiten können teilweise oder vollständig in Hard- oder auch in Software ausgeführt sein. Die bloße Nennung einiger Maßnahmen in mehreren verschiedenen abhängigen Patentansprüchen ist nicht dahingehend zu verstehen, dass eine Kombination dieser Maßnahmen nicht ebenfalls vorteilhaft verwendet werden kann. Ein Computerprogramm kann auf einem nichtflüchtigen Datenträger gespeichert/vertrieben werden, beispielsweise auf einem optischen Speicher oder auf einem Halbleiterlaufwerk (SSD). Ein Computerprogramm kann zusammen mit Hardware und/oder als Teil einer Hardware vertrieben werden, beispielsweise mittels des Internets oder mittels drahtgebundener oder drahtloser Kommunikationssysteme. Bezugszeichen in den Patentansprüchen sind nicht einschränkend zu verstehen.

## Patentansprüche

1. Sensor (14) zum Überwachen einer über eine Verteilstation (12) bereitgestellten elektrischen Leistung, mit:
einer Sensor-Kommunikationseinheit (28) zum Empfangen eines Synchronisierungssignals von einem Gateway (16), wobei das Synchronisierungssignal Informationen zu einer Uhrzeit des Gateways umfasst;
einer Synchronisierungseinheit (30) zum Synchronisieren einer Uhrzeit des Sensors mit der Uhrzeit des Gateways basierend auf dem Synchronisierungssignal; und
einer Messeinheit (26) zum Messen einer Stromstärke eines einen Spannungsleiter (24) eines Abgangs der Verteilstation durchfließenden Wechselstroms zu einem Abtastzeitpunkt, der basierend auf der Uhrzeit des Sensors definiert ist,
wobei die Sensor-Kommunikationseinheit zum Übermitteln der gemessenen Stromstärke und des zugehörigen Abtastzeitpunkts an das Gateway ausgebildet ist.

2. Sensor (14) nach Anspruch 1, wobei
die Messeinheit (26) einen induktiven Wandler mit einem den Spannungsleiter (24) umschließenden Kern umfasst, der zum Anbringen an den Spannungsleiter teilbar ausgebildet ist; und
der Kern vorzugsweise ein flexibles magnetisch leitfähiges Kernmaterial umfasst und weiter vorzugsweise aus mehreren Schichten aufgebaut ist.

3. Sensor (14) nach einem der vorstehenden Ansprüche, mit:
einem induktiven Wandler zum Gewinnen von Energie zum Versorgen des Sensors basierend auf dem Wechselstrom im Spannungsleiter (24); und
einem Energiespeicher (32) zum Puffern der gewonnenen Energie,
wobei der Sensor vorzugsweise zum Aufnehmen eines Betriebs ausgebildet ist, wenn ein Füllstand des Energiespeichers einen vordefinierten Mindeststand überschreitet.

4. Sensor (14) nach einem der vorstehenden Ansprüche, wobei die Sensor-Kommunikationseinheit (28)
zum drahtlosen Kommunizieren mit dem Gateway (16) ausgebildet ist, vorzugsweise über Bluetooth-Low-Energy, BLE; und/oder
zum Empfangen von Synchronisierungssignalen in periodischen Zeitintervallen ausgebildet ist.

5. Sensor (14) nach einem der vorstehenden Ansprüche, wobei
die Sensor-Kommunikationseinheit (28) zum Empfangen einer Aktualisierung einer Software des Sensors von dem Gateway (16) ausgebildet ist; und
die Software des Sensors vorzugsweise einer Software des Gateways, deren Funktion anhand einer unterschiedlichen Hardware-Beschaltung definiert ist, entspricht.

6. Sensor (14) nach einem der vorstehenden Ansprüche, wobei
der Sensor mehrere Messeinheiten (26) zum Messen von Stromstärken in mehreren Spannungsleitern (24) umfasst; und
die mehreren Messeinheiten vorzugsweise jeweils in separaten Gehäusen angeordnet sind und über Kabelverbindungen mit den weiteren Einheiten des Sensors verbunden sind.

7. Gateway (16) zum Überwachen einer über eine Verteilstation (12) bereitgestellten elektrischen Leistung, mit:
einer Gateway-Kommunikationseinheit (38) zum Übermitteln eines Synchronisierungssignals an einen Sensor (14), wobei das Synchronisierungssignal Informationen zu einer Uhrzeit des Gateways umfasst, und zum Empfangen einer Stromstärke eines einen Spannungsleiter (24) eines Abgangs der Verteilstation durchfließenden Wechselstroms und eines zugehörigen Abtastzeitpunkts von dem Sensor;
einer Versorgungseinheit (40) zum Empfangen einer Wechselstrom-Versorgungsspannung von der Verteilstation zur Energieversorgung des Gateways;
einem Spannungswandler (42) zum Messen einer Spannung der Wechselstrom-Versorgungsspannung zu einem Abtastzeitpunkt, der basierend auf der Uhrzeit des Gateways definiert ist; und
einer Auswerteeinheit (44) zum Ermitteln der elektrischen Leistung des Spannungsleiters basierend auf der gemessenen Spannung und der empfangenen Stromstärke.

8. Gateway (16) nach Anspruch 7, mit einer Verbindungseinheit (46) zum Kommunizieren mit einer Zentralstelle (18) und zum Übermitteln eines Energieparameters mit Informationen zu der ermittelten elektrischen Leistung des Spannungsleiters (24).

9. Gateway (16) nach Anspruch 8, wobei die Verbindungseinheit (46)
zum Empfangen eines Zeitsignals von der Zentralstelle (18) mit Informationen zu einer Uhrzeit der Zentralstelle und zum Synchronisieren der Uhrzeit des Gateways basierend auf dem Zeitsignal ausgebildet ist; und/oder
als Mobilkommunikationseinheit zum drahtlosen Kommunizieren über das Internet ausgebildet ist.

10. Gateway (16) nach einem der Ansprüche 7 bis 9, wobei die Auswerteeinheit (44) zum Ermitteln der elektrischen Leistung des Spannungsleiters (24) basierend auf einer Bestimmung einer Phasenlage der Wechselstrom-Versorgungsspannung und einer Phasenlage des den Spannungsleiter durchfließenden Wechselstroms auf Grundlage der gemessenen Spannung und der empfangenen Stromstärke ausgebildet ist.

11. Gateway (16) nach Anspruch 10, wobei die Auswerteeinheit (44)
zum Einspeisen eines Testsignals in die Wechselstrom-Versorgungsspannung ausgebildet ist, das mittels der Messeinheit (26) des Sensors (14) detektierbar ist; und
zum Bestimmen der Phasenlage der Wechselstrom-Versorgungsspannung und der Phasenlage des den Spannungsleiter (24) durchfließenden Wechselstroms basierend auf der empfangenen Stromstärke nach Einspeisen des Testsignals ausgebildet ist.

12. System (10) zum Überwachen einer über eine Verteilstation (12) bereitgestellten elektrischen Leistung, mit: einem Sensor (14) nach einem der Ansprüche 1 bis 6 und einem Gateway (16) nach einem der Ansprüche 7 bis 11, wobei
das System vorzugsweise eine entfernt angeordnete Zentralstelle (18) zum Sammeln und Weiterleiten von Informationen zu der über die Verteilstation bereitgestellten elektrischen Leistung umfasst.

13. Verfahren zum Überwachen einer über eine Verteilstation (12) bereitgestellten elektrischen Leistung in einem Gateway (16), mit den Schritten:
Übermitteln (S10) eines Synchronisierungssignals an einen Sensor (14), wobei das Synchronisierungssignal Informationen zu einer Uhrzeit des Gateways umfasst;
Empfangen (S12) einer Stromstärke eines einen Spannungsleiter (24) eines Abgangs der Verteilstation durchfließenden Wechselstroms und eines zugehörigen Abtastzeitpunkts von dem Sensor;
Empfangen (S14) einer Wechselstrom-Versorgungsspannung von der Verteilstation zur Energieversorgung des Gateways;
Messen (S16) einer Spannung der Wechselstrom-Versorgungsspannung zu einem Abtastzeitpunkt, der basierend auf der Uhrzeit des Gateways definiert ist; und
Ermitteln (S18) der elektrischen Leistung des Abgangs basierend auf der gemessenen Spannung und der empfangenen Stromstärke.

14. Verfahren zum Überwachen einer über eine Verteilstation (12) bereitgestellten elektrischen Leistung in einem Sensor (14), mit den Schritten:
Empfangen (S30) eines Synchronisierungssignals von einem Gateway (16), wobei das Synchronisierungssignal Informationen zu einer Uhrzeit des Gateways umfasst;
Synchronisieren (S32) einer Uhrzeit des Sensors mit der Uhrzeit des Gateways basierend auf dem Synchronisierungssignal; und
Messen (S34) einer Stromstärke eines einen Spannungsleiter (24) eines Abgangs der Verteilstation durchfließenden Wechselstroms zu einem Abtastzeitpunkt, der basierend auf der Uhrzeit des Sensors definiert ist,
Übermitteln (S36) der gemessenen Stromstärke und des zugehörigen Abtastzeitpunkts an das Gateway.

15. Computerprogrammprodukt mit Programmcode zum Durchführen der Schritte des Verfahrens nach einem der Ansprüche 13 und 14, wenn der Programmcode auf einem Computer ausgeführt wird.
